(19) **Europäisches Patentamt / European Patent Office / Office européen des brevets**

(11) **EP 4 780 168 A1**

(12) # EUROPEAN PATENT APPLICATION
published in accordance with Art. 153(4) EPC

(43) Date of publication:
**22.07.2026 Bulletin 2026/30**

(21) Application number: **24865160.6**

(22) Date of filing: **16.08.2024**

(51) International Patent Classification (IPC):
**H10F 10/167** (2025.01)     **H10F 30/295** (2025.01)

(52) Cooperative Patent Classification (CPC):
**H10F 10/17;** Y02E 10/541; Y02P 70/50

(86) International application number:
**PCT/JP2024/029137**

(87) International publication number:
**WO 2025/057654 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.09.2023 JP 2023146962**

(71) Applicants:
• **PXP Corporation
Sagamihara-shi, Kanagawa 252-0203 (JP)**
• **SOLABLE Inc.
Tokyo 100-7014 (JP)**

(72) Inventors:
• **SUGIMOTO, Hiroki
Sagamihara-shi, Kanagawa 252-0203 (JP)**
• **FUKASAWA, Kazuhito
Sagamihara-shi, Kanagawa 252-0203 (JP)**
• **KAWAHARA, Mayo
Sagamihara-shi, Kanagawa 252-0203 (JP)**
• **HIRAI, Yoshiaki
Sagamihara-shi, Kanagawa 252-0203 (JP)**

(74) Representative: **EIP
Fairfax House
15 Fulwood Place
London WC1V 6HU (GB)**

(54) **SOLAR CELL AND MANUFACTURING METHOD FOR SOLAR CELL**

(57)     An object of the present invention is to provide a solar cell having high heat resistance and low manufacturing costs, and to provide a manufacturing method for the solar cell. The present invention relates to a solar cell including at least, in the following order, a first electrode layer, a light absorption layer, a first electron transport layer that is an n-type semiconductor containing indium sulfide or indium sulfide to which another element is added, a second electron transport layer that is an n-type oxide semiconductor to which a hydrogen element is added, and a second electrode layer.

[Fig. 1]

EP 4 780 168 A1

## Description

### Technical Field

The present invention relates to a solar cell and a manufacturing method for a solar cell.

### Background Art

Solar cells include a chalcopyrite solar cell using a chalcopyrite compound or a kesterite solar cell using a kesterite compound. In order to improve various physical properties of the chalcopyrite solar cell or the kesterite solar cell, various studies have been conducted as disclosed in Non-Patent Literatures 1 and 2 and Patent Literatures 1 and 2.

In the chalcopyrite solar cell or the kesterite solar cell, various physical properties are improved by including an alkali metal element such as Na and K in a light absorption layer, and thus high performance is expected. However, since the alkali metal element is easily diffused by heating or applying an electric field, when the above-described solar cell having the light absorption layer including the alkali metal element as disclosed in Non-Patent Literature 1 is exposed to high temperature, the alkali metal element is diffused from the light absorption layer to a transparent conductive film on a light receiving surface side, and thus the performance of the solar cell is deteriorated. Therefore, it is difficult to use the above-described solar cell having the light absorption layer including the alkali metal element in a high temperature environment exceeding a normal use temperature range of the solar cell, which is 45°C to 85°C.

In Non-Patent Literature 2, it is suggested that $In_2S_3$, which is usually used as an n-type electron transport layer laminated on a p-type chalcopyrite light absorption layer or a p-type kesterite light absorption layer, acts as a diffusion prevention layer of the alkali metal element, and is expected as a material for an electron transport layer having heat resistance.

Therefore, a solar cell in which a first electron transport layer using $In_2S_3$ is formed on the light absorption layer and a second electron transport layer is formed on the first electron transport layer is disclosed in Patent Literature 1 and Patent Literature 2.

### Citation List

### Patent Literatures

Patent Literature 1: Chinese Patent No. 1820358
Patent Literature 2: Japanese Patent No. 5635497

### Non-Patent Literatures

Non-Patent Literature 1: Prog. Photovolt: Res. Appl., 2015, 23, pp. 537-545
Non-Patent Literature 2: Appl. Sci., 2020, 10, pp. 1052

### Summary of Invention

### Technical Problem

However, it has been found that, since $In_2S_3$ is easily damaged by sputtering, when producing the solar cell disclosed in Patent Literature 1 and Patent Literature 2, if the second electron transport layer is formed on the first electron transport layer using $In_2S_3$ by sputtering, the first electron transport layer is damaged, and the performance of the solar cell is deteriorated or the solar cell does not function as the solar cell. On the other hand, it has been found that, if the second electron transport layer is formed on the first electron transport layer by a method such as an atomic layer deposition method that is less likely to cause the above-described damage by sputtering in order to avoid damage to the first electron transport layer by sputtering, mass productivity is deteriorated, and a problem that manufacturing costs of the solar cell are increased occurs.

An object of the present invention is to provide a solar cell having high heat resistance and low manufacturing costs, and to provide a manufacturing method for the solar cell.

**Solution to Problem**

A solar cell according to an aspect of the present invention includes at least, in the following order, a first electrode layer, a light absorption layer, a first electron transport layer that is an n-type semiconductor containing indium sulfide or indium sulfide to which another element is added, a second electron transport layer that is an n-type oxide semiconductor to which a hydrogen element is added, and a second electrode layer.

The present inventors have found that, in the solar cell, heat resistance tends to be improved by including the first electron transport layer that is the n-type semiconductor containing indium sulfide or indium sulfide to which another element is added, and the second electron transport layer that is the n-type oxide semiconductor to which a hydrogen element is added. In addition, the present inventors have found that the second electron transport layer can be formed by sputtering, and thus manufacturing costs tend to be reduced.

In a manufacturing method for a solar cell according to an aspect of the present invention, the solar cell includes at least, in the following order, a first electrode layer, a light absorption layer, a first electron transport layer that is an n-type semiconductor containing indium sulfide or indium sulfide to which another element is added, a second electron transport layer that is an n-type oxide semiconductor to which a hydrogen element is added, and a second electrode layer, and the manufacturing method includes a first electron transport layer-forming step of forming the first electron transport layer on a substrate including the light absorption layer by sputtering, and a second electron transport layer-forming step of forming the second electron transport layer on the first electron transport layer by sputtering while supplying a gas including an oxygen source and a hydrogen source.

The present inventors have found that, in the manufacturing method for a solar cell, heat resistance tends to be improved by including the first electron transport layer that is the n-type semiconductor containing indium sulfide or indium sulfide to which another element is added, and the second electron transport layer that is the n-type oxide semiconductor to which a hydrogen element is added. In addition, the present inventors have found that the second electron transport layer can be formed by sputtering, and thus manufacturing costs tend to be reduced. In addition, the present inventors have found that, in the manufacturing method for a solar cell, the second electron transport layer can be formed on the first electron transport layer without damaging the first electron transport layer by performing sputtering while supplying the gas including the oxygen source and the hydrogen source, and thus the manufacturing costs tend to be reduced.

**Advantageous Effect of Invention**

According to the present invention, it is possible to provide a solar cell having high heat resistance and low manufacturing costs, and a manufacturing method for a solar cell.

**Brief Description of Drawings**

[Figure 1] Figure 1 is a view showing an example of a cross-sectional structure of a solar cell.
[Figure 2] Figure 2 is diagrams showing evaluation results of FF values.

**Description of Embodiments**

Hereinafter, embodiments (hereinafter, referred to as "the present embodiments") for carrying out the present invention will be described in detail with reference to drawings as necessary. However, the present invention is not limited thereto, and various modifications are possible without departing from the gist. Incidentally, in the drawings, the same elements will be represented by the same reference numerals, and duplicate descriptions thereof will be omitted. Unless otherwise specifically described, the positional relationship such as up, down, left and right will be based on the positional relationship shown in the drawings. The dimensional ratios shown in the drawings are not limited to the depicted ratios.

1. Solar cell

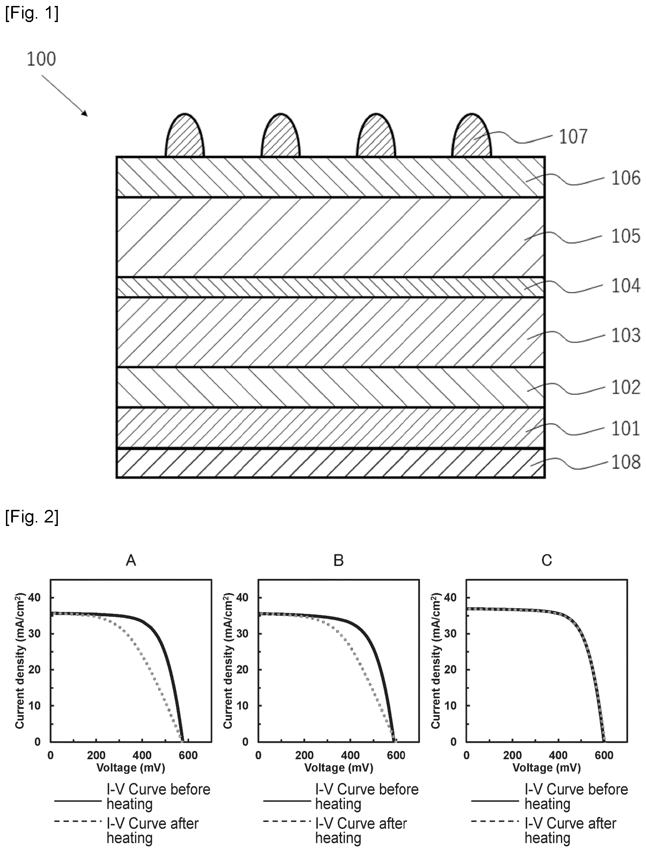

Figure 1 is a view showing an example of a cross-sectional structure of a solar cell according to an embodiment of the present invention.

For example, as shown in Figure 1, a solar cell 100 according to the present embodiment includes a substrate 108, a first electrode layer 101 provided on the substrate 108, a hole transport layer 102 provided on the first electrode layer 101, a light absorption layer 103 provided on the hole transport layer 102, a first electron transport layer 104 provided on the light absorption layer 103, a second electron transport layer 105 provided on the first electron transport layer 104, a second electrode layer 106 provided on the second electron transport layer 105, and a grid electrode 107 provided on the second electrode layer 106. The solar cell 100 receives light from the second electrode layer 106 side to generate power.

Although not shown, the solar cell 100 according to the present embodiment may include another layer between the layers, above, or below as necessary. For example, the hole transport layer 102 may include a first hole transport layer and a second hole transport layer, and the solar cell may include, on the grid electrode 107, a contamination prevention layer for preventing contamination from the outside.

Although not shown, in the solar cell 100 according to the present embodiment, the hole transport layer 102, the light absorption layer 103 provided on the hole transport layer 102, the first electron transport layer 104 provided on the light absorption layer 103, the second electron transport layer 105 provided on the first electron transport layer 104, and the second electrode layer 106 provided on the second electron transport layer 105 are taken as one set, and two sets or three sets of the above set may be laminated on the first electrode layer 101. In addition, the grid electrode 107 may be provided on the uppermost second electrode layer 106.

The solar cell 100 according to the present embodiment includes at least, in the following order, the first electrode layer 101, the light absorption layer 103, the first electron transport layer 104 that is an n-type semiconductor containing indium sulfide or indium sulfide to which another element is added, the second electron transport layer 105 that is an n-type oxide semiconductor to which a hydrogen element is added, and the second electrode layer 106. In the solar cell 100 according to the present embodiment, the first electron transport layer 104 that is the n-type semiconductor containing indium sulfide or indium sulfide to which another element is added is provided between the light absorption layer 103 and the second electron transport layer 105, so that even when the solar cell 100 is exposed to a high temperature environment, alkali metal elements contained in the light absorption layer 103 can be prevented from being diffused to the second electrode layer 106; and as a result, the solar cell 100 tends to have excellent heat resistance. It is considered that this is because the first electron transport layer 104 that is the n-type semiconductor containing indium sulfide or indium sulfide to which another element is added functions as a diffusion prevention layer for preventing the alkali metal element of the light absorption layer 103 from diffusing, but the cause thereof is not limited thereto.

In addition, in the solar cell in the related art, when the electron transport layer in the solar cell is formed in a two-layer structure and the electron transport layer on the light absorption layer side contains indium sulfide in order to improve the heat resistance, if the other electron transport layer is formed on the electron transport layer containing indium sulfide by sputtering, the electron transport layer containing indium sulfide is easily damaged, so that the other electron transport layer cannot be formed by sputtering. Therefore, in the solar cell in the related art, it is necessary to form the other electron transport layer while suppressing the damage to the electron transport layer containing indium sulfide by a high-cost film forming method such as an atomic layer deposition method and a chemical solution deposition method. In addition, since most of steps in the manufacturing method for the solar cell are dry processes while the film forming method such as the chemical solution deposition method is a wet process, when the wet process is used only for forming the other electron transport layer, there is a disadvantage that the manufacturing costs are high and the manufacturing takes time.

On the other hand, in the solar cell 100 according to the present embodiment, the n-type oxide semiconductor to which a hydrogen element is added is used as the second electron transport layer 105, the second electron transport layer 105 can be formed on the first electron transport layer 104 by sputtering, and it is not necessary to use the high-cost film forming method such as the atomic layer deposition method and the chemical solution deposition method. It is considered that this is because the film formation by sputtering of the n-type oxide semiconductor to which a hydrogen element is added can be performed under an environment in which the damage to the n-type semiconductor containing indium sulfide or indium sulfide to which another element is added can be reduced as compared with the film formation by sputtering of an n-type oxide semiconductor to which a hydrogen element is not added, but the cause thereof is not limited thereto. In addition, since sputtering is a dry process as in the steps other than the film formation of the electron transport layer in the manufacturing method for the solar cell, the solar cell 100 can be manufactured by preparing only the environment for the dry process without preparing both of the environments for the wet process and for the dry process when manufacturing the solar cell 100, so that the manufacturing costs tend to be reduced and the time required for the manufacturing tends to be reduced.

Therefore, it is considered that the solar cell 100 according to the present embodiment has high heat resistance and low manufacturing costs. However, the cause thereof is not limited to the above.

A thickness of the solar cell 100, excluding the substrate 108, is not particularly limited, and is, for example, 1.0 $\mu$m or more and 10.0 $\mu$m or less, 1.1 $\mu$m or more and 8.0 $\mu$m or less, or 1.2 $\mu$m or more and 6.0 $\mu$m or less.

The solar cell 100 according to the embodiment of the present invention can constitute a thin film solar cell by forming each layer to be sufficiently thin.

Hereinafter, each configuration that can be included in the solar cell 100 will be described in detail.

In the present embodiment, when a compound is expressed by name, not only the pure compound itself but also the compound to which a trace amount of an element or the like is added within a range in which characteristics of the compound are not lost is included.

In addition, in the present embodiment, since the element in each layer of the solar cell can be present in different oxidation states, all the oxidation states are referred to by the name of the element unless otherwise specified. For example, "hydrogen element" means a hydrogen atom, a hydrogen ion, a hydride ion, hydrogen in the form of a compound, and hydrogen in an elemental state.

### 1.1. Substrate

The substrate 108 is not particularly limited, and for example, a glass substrate such as soda-lime glass and low alkali glass, a metal substrate such as a stainless steel plate and an aluminum foil, or a resin substrate such as a polyimide resin substrate and an epoxy resin substrate can be used. A thickness of the substrate 108 is not particularly limited, and is, for example, 10 $\mu$m or more and 500 $\mu$m or less, 20 $\mu$m or more and 250 $\mu$m or less, or 30 $\mu$m or more and 100 $\mu$m or less. When the thickness of the substrate 108 is within the above-described range, the solar cell tends to be lightened or flexible.

### 1.2. First electrode layer

The first electrode layer 101 is provided, for example, to extract a current caused by holes generated in the light absorption layer 103 described later. The first electrode layer 101 is not particularly limited as long as it has conductivity, and for example, a metal conductive layer using a metal such as Mo, Cr, and Ti as a material; a conductive inorganic compound layer using a conductive inorganic compound other than the metal as a material; or a conductive organic compound layer using a conductive organic compound as a material can be used. A thickness of the first electrode layer 101 is not particularly limited, and is, for example, 200 nm or more and 800 nm or less, or 300 nm or more and 700 nm or less. When the thickness of the first electrode layer 101 is within the above-described range, the solar cell tends to be lightened or flexible while the current can be sufficiently extracted without loss.

### 1.3. Hole transport layer

The solar cell 100 according to the present embodiment may include the hole transport layer 102. The hole transport layer 102 has, for example, a function of efficiently extracting the holes generated in the light absorption layer 103 described later from the light absorption layer 103, and preventing electrons generated at the same time as the holes in the light absorption layer 103 described later from recombining with the holes. The hole transport layer 102 is preferably a p-type semiconductor. A substance contained in the p-type semiconductor is not particularly limited, and examples thereof include inorganic compounds such as nickel oxide, molybdenum oxide, copper gallium oxide, copper aluminum oxide, molybdenum selenide, and molybdenum selenide sulfide. The p-type semiconductor in the hole transport layer 102 may be used alone or in combination of two or more kinds thereof.

The hole transport layer 102 is preferably substantially composed of the above-described inorganic compound, and is preferably formed of the above-described inorganic compound. In addition, a content of the above-described inorganic compound in the hole transport layer 102 is preferably 80% by mass or more and 100% by mass or less, 90% by mass or more and 100% by mass or less, 95% by mass or more and 100% by mass or less, or 99% by mass or more and 100% by mass or less with respect to the total amount of the hole transport layer 102.

A thickness of the hole transport layer 102 is preferably 10 nm or more and 100 nm or less, 15 nm or more and 80 nm or less, or 20 nm or more and 60 nm or less. When the thickness of the hole transport layer 102 is within the above-described range, the solar cell tends to be lightened or flexible while the hole transport layer 102 has a function of efficiently extracting the holes generated in the light absorption layer 103 described later from the light absorption layer 103, and preventing electrons generated at the same time as the holes in the light absorption layer 103 described later from recombining with the holes.

### 1.4. Light absorption layer

The light absorption layer 103 has, for example, a function of absorbing near-infrared light, visible light, ultraviolet light, or the like to generate electrons and holes. Examples of the near-infrared light, visible light, ultraviolet light, or the like include sunlight. The light absorption layer 103 preferably contains a chalcopyrite compound or a kesterite compound. The chalcopyrite compound may be used alone or in combination of two or more kinds thereof. In addition, the kesterite compound may be used alone or in combination of two or more kinds thereof.

Preferred examples of the chalcopyrite compound include an I-III-VI$_2$ group chalcopyrite compound. The I-III-VI$_2$ group chalcopyrite compound is not particularly limited, and examples thereof include $CuAlS_2$, $CuAlSe_2$, $CuAlTe_2$, $CuGaS_2$, $CuGaSe_2$, $CuGaTe_2$, $CuInS_2$, $CuInSe_2$, $CuInTe_2$, $AgAlS_2$, $AgAlSe_2$, $AgAlTe_2$, $AgGaS_2$, $AgGaSe_2$, $AgGaTe_2$, $AgInS_2$, $AgInSe_2$, $AgInTe_2$, and combinations thereof. The "combinations thereof" is not particularly limited, and examples thereof include $Cu(In_xGa_{1-x})(Se_yS_{1-y})_2$ ($0 \leq x \leq 1$, $0 \leq y \leq 1$) when $CuGaS_2$ and $CuInSe_2$ are combined. Among these chalcopyrite compounds, $CuGaS_2$, $CuGaSe_2$, $CuInS_2$, $CuInSe_2$, or $Cu(In_xGa_{1-x})(Se_yS_{1-y})_2$ ($0 \leq x \leq 1$, $0 \leq y \leq 1$) is preferable, and $Cu(In_xGa_{1-x})(Se_yS_{1-y})_2$ ($0 \leq x \leq 1$, $0 \leq y \leq 1$) is more preferable. In the present embodiment, a CIS compound is a chalcopyrite compound including Cu, In, and Se, a CIGS compound is a chalcopyrite compound including Cu, In, Ga, and Se, and a CIGSS compound is a chalcopyrite compound including Cu, In, Ga, Se, and S.

Preferred examples of the kesterite compound include an $I_2$-II-IV-$VI_4$ group kesterite compound. The $I_2$-II-IV-$VI_4$ group kesterite compound is not particularly limited, and examples thereof include $Cu_2ZnSnS_4$, $Cu_2ZnSnSe_4$, $Cu_2ZnGeS_4$, $Cu_2ZnGeSe_4$, $Cu_2MnSnS_4$, $Cu_2MnSnSe_4$, $Cu_2MnGeS_4$, $Cu_2MnGeSe_4$, $Ag_2ZnSnS_4$, $Ag_2ZnSnSe_4$, $Ag_2ZnGeS_4$, $Ag_2ZnGeSe_4$, $Ag_2MnSnS_4$, $Ag_2MnSnSe_4$, $Ag_2MnGeS_4$, $Ag_2MnGeSe_4$, and combinations thereof. The "combinations thereof" is not particularly limited, and examples thereof include $(Cu_xAg_{1-x})_2ZnSn(S_ySe_{1-y})_4$ ($0 \leq x \leq 1$) when $Cu_2ZnSnS_4$ and $Ag_2ZnSnSe_4$ are combined. Examples thereof also include $Cu_2ZnSn(S_xSe_{1-x})_4$ ($0 \leq x \leq 1$, $0 \leq y \leq 1$). Among these kesterite compounds, $Cu_2ZnSnS_4$, $Cu_2ZnSnSe_4$, $Ag_2ZnSnS_4$, $Ag_2ZnSnSe_4$, or $(Cu_xAg_{1-x})_2ZnSn(S_ySe_{1-y})_4$ ($0 \leq x \leq 1$, $0 \leq y \leq 1$) is preferable, and $(Cu_xAg_{1-x})_2ZnSn(S_ySe_{1-y})_4$ ($0 \leq x \leq 1$, $0 \leq y \leq 1$) is more preferable. In the present embodiment, a CZTS compound is a kesterite compound including Cu, Zn, Sn, and S, an ACZTS compound is a kesterite compound including Ag, Cu, Zn, Sn, and S, and an ACZTSS compound is a kesterite compound including Ag, Cu, Zn, Sn, S, and Se.

A content of the above-described chalcopyrite compound and the above-described kesterite compound in the light absorption layer 103 is not particularly limited as long as the light absorption layer 103 has the function of absorbing visible light, ultraviolet light, or the like to generate electrons and holes. More specifically, the content of the above-described chalcopyrite compound and the above-described kesterite compound is not particularly limited, and is 50% by mass or more and 100% by mass or less, 60% by mass or more and 100% by mass or less, 70% by mass or more and 100% by mass or less, 80% by mass or more and 100% by mass or less, or 90% by mass or more and 100% by mass or less with respect to the total mass of the light absorption layer 103.

The light absorption layer 103 preferably contains an alkali metal element. As the alkali metal element, it is more preferable to contain sodium, potassium, rubidium, or cesium. When the light absorption layer 103 contains the alkali metal element, a conversion efficiency of the solar cell tends to be improved.

A content of the alkali metal element in the light absorption layer 103 is preferably 0% by mass or more and 2.0% by mass or less, 0% by mass or more and 1.0% by mass or less, or 0% by mass or more and 0.5% by mass or less.

The content of the alkali metal element in the light absorption layer 103 can be measured, for example, by ICP, EDX, or SIMS, but the present invention is not limited thereto.

A thickness of the light absorption layer 103 is preferably 0.5 $\mu$m or more and 10.0 $\mu$m or less, 0.5 $\mu$m or more and 7.5 $\mu$m or less, 0.5 $\mu$m or more and 5.0 $\mu$m or less, or 0.5 $\mu$m or more and 3.0 $\mu$m or less. When the thickness of the light absorption layer 103 is within the above-described range, the solar cell tends to be lightened or flexible while the light absorption layer 103 has the function of absorbing visible light, ultraviolet light, or the like to generate electrons and holes.

The solar cell 100 according to the present embodiment may include two layers of the light absorption layer 103. In this case, a substance contained in the first light absorption layer 103 and a substance contained in the second light absorption layer 103 may be different from or the same as each other, but are preferably different from each other. When the solar cell 100 includes two layers of the light absorption layer 103, a wavelength range of light that can be absorbed by the light absorption layer 103 tends to be expanded, and as a result, the performance of the solar cell tends to be improved. In addition, the solar cell 100 according to the present embodiment may include three or more layers of the light absorption layer 103.

1.5. First electron transport layer

The first electron transport layer 104 is an n-type semiconductor containing indium sulfide or indium sulfide to which another element is added, and has a function of preventing the alkali metal element contained in the light absorption layer 103 from being diffused to the second electrode layer 106 and a function of efficiently extracting the electrons generated in the light absorption layer 103 from the light absorption layer 103 and preventing holes generated at the same time as the electrons in the light absorption layer 103 from recombining with the electrons. Here, the "another element" means an element other than a sulfur element and an indium element. Preferred examples of another element include an oxygen element and an alkali metal element. Another element may be used alone or in combination of two or more kinds thereof. In addition, the alkali metal element is preferably sodium or potassium, and the alkali metal element may be used alone or in combination of two or more kinds thereof.

From the viewpoint of more reliably exhibiting the function of the first electron transport layer 104, in the indium sulfide to which another element is added, a molar ratio of another element to the total molar of the sulfur element and the indium element is preferably more than 0 and 2.0 or less, 0.1 or more and 1.8 or less, 0.2 or more and 1.6 or less, or 0.3 or more and 1.4 or less.

Regarding indium sulfide to which an oxygen element is added, from the viewpoint of more reliably exhibiting the function of the first electron transport layer 104, a molar ratio $\alpha$ of the oxygen element to the sulfur element is preferably more than 0 and 2.4 or less, 0.1 or more and 2.2 or less, 0.2 or more and 2.0 or less, 0.3 or more and 1.9 or less, 0.4 or more and 1.8 or less, or 0.5 or more and 1.7 or less.

Regarding indium sulfide to which an alkali metal element is added, from the viewpoint of more reliably exhibiting the function of the first electron transport layer 104, a molar ratio $\beta$ of the alkali metal element to the indium element is preferably more than 0 and 1.3 or less, 0.1 or more and 1.2 or less, 0.2 or more and 1.1 or less, 0.3 or more and 1.0 or less, 0.4 or more and 0.9 or less, or 0.5 or more and 0.8 or less.

Regarding indium sulfide to which an oxygen element and an alkali metal element are added, from the viewpoint of more reliably exhibiting the function of the first electron transport layer 104, the molar ratio $\alpha$ of the oxygen element to the sulfur element and the molar ratio $\beta$ of the alkali metal element to the indium element are preferably $0 < \alpha \leq 2.4$ and $0 < \beta \leq 1.3$, $0.1 \leq \alpha \leq 2.2$ and $0.1 \leq \beta \leq 1.2$, $0.2 \leq \alpha \leq 2.0$ and $0.2 \leq \beta \leq 1.1$, $0.3 \leq \alpha \leq 1.9$ and $0.3 \leq \beta \leq 1.0$, $0.4 \leq \alpha \leq 1.8$ and $0.4 \leq \beta \leq 0.9$, or $0.5 \leq \alpha \leq 1.7$ and $0.5 \leq \beta \leq 0.8$.

The first electron transport layer 104 that is the n-type semiconductor is preferably substantially composed of indium sulfide or indium sulfide to which another element is added, and preferably formed of indium sulfide or indium sulfide to which another element is added. In addition, a content of the indium sulfide and the indium sulfide to which the other element is added in the first electron transport layer 104 that is the n-type semiconductor is preferably 80% by mass or more and 100% by mass or less, 90% by mass or more and 100% by mass or less, 95% by mass or more and 100% by mass or less, or 99% by mass or more and 100% by mass or less with respect to the total amount of the first electron transport layer 104.

A thickness of the first electron transport layer 104 is preferably 10 nm or more and 40 nm or less, 15 nm or more and 35 nm or less, or 17 nm or more and 30 nm or less. When the thickness of the first electron transport layer 104 is within the above-described range, the solar cell tends to be lightened or flexible while the first electron transport layer 104 has the function of preventing the alkali metal element contained in the light absorption layer 103 from being diffused to the second electrode layer 106 and the function of efficiently extracting the electrons generated in the light absorption layer 103 from the light absorption layer 103 and preventing holes generated at the same time as the electrons in the light absorption layer 103 from recombining with the electrons. In addition, a band gap of the indium sulfide is approximately 2.1 eV and a transmittance of the sunlight is not high, but when the thickness of the first electron transport layer 104 is within the above-described range, the transmittance of the sunlight in the first electron transport layer 104 is improved, and thus the performance of the solar cell tends to be improved. In addition, the indium sulfide has a high resistance, but when the thickness of the first electron transport layer 104 is within the above-described range, the high resistance is suppressed from adversely affecting the performance of the solar cell, and thus the performance of the solar cell tends to be improved.

1.6. Second electron transport layer

The second electron transport layer 105 is an n-type oxide semiconductor to which a hydrogen element is added, and has a function of efficiently extracting the electrons generated in the light absorption layer 103 from the light absorption layer 103 and preventing holes generated at the same time as the electrons in the light absorption layer 103 from recombining with the electrons.

A band gap of the n-type oxide semiconductor to which a hydrogen element is added is preferably 3.3 eV or more, 3.4 eV or more, 3.5 eV or more, or 3.6 eV or more. In addition, the band gap of the n-type oxide semiconductor to which a hydrogen element is added is not particularly limited, and is, for example, 3.3 eV or more and 5.0 eV or less, 3.4 eV or more and 4.5 eV or less, or 3.5 eV or more and 4.0 eV or less. When the band gap is within the above-described numerical range, the transmittance of the second electron transport layer 105 is improved, so that the amount of light absorbed by the light absorption layer 103 is increased, and as a result, the conversion efficiency of the solar cell tends to be improved.

As a method of measuring the band gap, a known method can be used. More specifically, the band gap is measured by, for example, a spectroscopic transmittance measurement, a spectroscopic quantum efficiency measurement, or the like; but the present invention is not particularly limited thereto.

A carrier concentration of the n-type oxide semiconductor to which a hydrogen element is added is preferably $1.0 \times 10^{20}$ cm$^{-3}$ or less, $5.0 \times 10^{19}$ cm$^{-3}$ or less, or $2.5 \times 10^{19}$ cm$^{-3}$ or less. In addition, the carrier concentration of the n-type oxide semiconductor to which a hydrogen element is added is not particularly limited, and is, for example, $1.0 \times 10^{16}$ cm$^{-3}$ or more and $1.0 \times 10^{20}$ cm$^{-3}$ or less, $1.0 \times 10^{17}$ cm$^{-3}$ or more and $5.0 \times 10^{19}$ cm$^{-3}$ or less, or $1.0 \times 10^{18}$ cm$^{-3}$ or more and $2.5 \times 10^{19}$ cm$^{-3}$ or less. When the carrier concentration is within the above-described numerical range, the electrons generated in the light absorption layer 103 can be efficiently extracted from the light absorption layer 103, so that it is possible to prevent holes generated at the same time as the electrons in the light absorption layer 103 from recombining with the electrons, and as a result, the conversion efficiency of the solar cell tends to be improved.

As a method of measuring the carrier concentration, a known method can be used. More specifically, the carrier concentration is measured by, for example, a Hall measurement or the like; but the present invention is not particularly limited thereto.

A refractive index of the n-type oxide semiconductor to which a hydrogen element is added is preferably 2.1 or more. In addition, the refractive index of the n-type oxide semiconductor to which a hydrogen element is added is not particularly limited, and is, for example, 2.1 or more and 2.8 or less, or 2.1 or more and 2.6 or less. The first electron transport layer 104 is an n-type semiconductor containing indium sulfide or indium sulfide to which another element is added, and the refractive index of the indium sulfide is a large value of approximately 2.8, so that the refractive index of the first electron transport layer 104 is also large. Therefore, when a semiconductor having a low refractive index is used as the second electron transport layer 105, reflection of light at an interface between the electron transport layers is large, and as a result, the performance of the solar cell tends to be deteriorated. On the other hand, when the n-type oxide semiconductor to which a hydrogen element is added and having a refractive index within the above-described numerical range is used as the second electron transport layer 105, the reflection of light at the interface between the first electron transport layer 104 and the second electron transport layer 105 can be suppressed, and as a result, the conversion efficiency of the solar cell tends to be improved.

As a method of measuring the refractive index, a known method can be used. More specifically, the refractive index is measured by, for example, a spectroscopic transmittance measurement, a spectroscopic ellipsometry measurement, or the like; but the present invention is not particularly limited thereto.

A specific resistivity of the n-type oxide semiconductor to which a hydrogen element is added is preferably $1.6 \times 10^{-2}$ $\Omega$cm or more, $1.8 \times 10^{-2}$ $\Omega$cm or more, or $2.0 \times 10^{-2}$ $\Omega$cm or more. In addition, the specific resistivity of the n-type oxide semiconductor to which a hydrogen element is added is not particularly limited, and is, for example, $1.6 \times 10^{-2}$ $\Omega$cm or more and $1.0 \times 10^2$ $\Omega$cm or less, $1.8 \times 10^{-2}$ $\Omega$cm or more and $10.0$ $\Omega$cm or less, or $2.0 \times 10^{-2}$ $\Omega$cm or more and $1.0$ $\Omega$cm or less. When the specific resistivity is within the above-described numerical range, the conversion efficiency of the solar cell tends to be improved.

As a method of measuring the specific resistivity, a known method can be used. More specifically, the specific resistivity is measured by, for example, a four-probe method; but the present invention is not particularly limited thereto.

As the n-type oxide semiconductor to which a hydrogen element is added, a semiconductor having a band gap of 3.3 eV or more, a carrier concentration of $1.0 \times 10^{20}$ $cm^{-3}$ or less, and a refractive index of 2.1 or more is preferable. Furthermore, as the n-type oxide semiconductor to which a hydrogen element is added, a semiconductor having a band gap of 3.3 eV or more, a carrier concentration of $1.0 \times 10^{20}$ $cm^{-3}$ or less, a refractive index of 2.1 or more, and a specific resistivity of $1.6 \times 10^{-2}$ $\Omega$cm or more is preferable.

Preferred examples of a substance contained in the n-type oxide semiconductor as the n-type oxide semiconductor to which a hydrogen element is added and having a band gap of 3.3 eV or more, a carrier concentration of $1.0 \times 10^{20}$ $cm^{-3}$ or less, a refractive index of 2.1 or more, and a specific resistivity of $1.6 \times 10^{-2}$ $\Omega$cm or more include titanium oxide, zinc oxide to which a sulfur element is added, or zinc oxide to which a titanium element is added. Among the above, zinc oxide to which a titanium element is added is preferable. The n-type oxide semiconductor may be used alone or in combination of two or more kinds thereof.

Regarding the zinc oxide to which a sulfur element is added, from the viewpoint of more reliably exhibiting the function of the second electron transport layer 105, a molar ratio of the sulfur element to the oxygen element is preferably 0 or more and 0.7 or less, or 0.1 or more and 0.4 or less.

Regarding the zinc oxide to which a titanium element is added, from the viewpoint of more reliably exhibiting the function of the second electron transport layer 105, a molar ratio of the titanium element to the zinc element is preferably 0 or more and 0.3 or less, or 0.05 or more and 0.2 or less.

In the n-type oxide semiconductor to which a hydrogen element is added, from the viewpoint of more reliably exhibiting the function of the second electron transport layer 105, a molar ratio of the hydrogen element to all metal elements is preferably 0.001 or more and 0.030 or less, 0.005 or more and 0.020 or less, 0.007 or more and 0.015 or less, or 0.009 or more and 0.013 or less.

The second electron transport layer 105 that is the n-type oxide semiconductor to which a hydrogen element is added may be an electron transport layer formed by a method in a second electron transport layer-forming step described later.

The second electron transport layer 105 that is the n-type oxide semiconductor is preferably substantially composed of titanium oxide, zinc oxide to which a sulfur element is added, or zinc oxide to which a titanium element is added; and preferably formed of titanium oxide, zinc oxide to which a sulfur element is added, or zinc oxide to which a titanium element is added. In addition, a content of the titanium oxide, the zinc oxide to which a sulfur element is added, and the zinc oxide to which a titanium element is added in the second electron transport layer 105 that is the n-type oxide semiconductor is preferably 80% by mass or more and 100% by mass or less, 90% by mass or more and 100% by mass or less, 95% by mass or more and 100% by mass or less, or 99% by mass or more and 100% by mass or less with respect to the total amount of the second electron transport layer 105.

A thickness of the second electron transport layer 105 is preferably 50 nm or more and 120 nm or less, 55 nm or more and 110 nm or less, or 60 nm or more and 100 nm or less. When the thickness of the second electron transport layer 105 is within the above-described range, the solar cell tends to be lightened or flexible while the second electron transport layer 105 has the function of efficiently extracting the electrons generated in the light absorption layer 103 from the light absorption layer 103 and preventing holes generated at the same time as the electrons in the light absorption layer 103 from recombining with the electrons.

1.7. Second electrode layer

The second electrode layer 106 is provided, for example, to extract a current caused by the electrons generated in the light absorption layer 103. In addition, in the solar cell 100, since the light absorption layer 103 absorbs light passing through the second electrode layer 106, the second electrode layer 106 is preferably a transparent electrode layer in order to increase the amount of light absorbed by the light absorption layer 103. The transparent electrode is an electrode using a material having both high electrical conductivity and high visible light transmittance. The high electrical conductivity is not particularly limited, and means, for example, that a specific resistivity is $5.0 \times 10^{-3}$ $\Omega$cm or less. The high visible light transmittance is not particularly limited, and means, for example, that an average transmittance in a wavelength range of 400 to 1,300 nm is 80% or more. As a material for the transparent electrode, a known material can be used, and examples thereof include indium tin oxide (ITO), hydrogen-containing indium oxide (IOH), fluorine-containing tin oxide (FTO), boron-containing zinc oxide (ZnO:B), and aluminum-containing zinc oxide (ZnO:Al).

A content of the above-described material in the second electrode layer 106 is not particularly limited as long as the second electrode layer 106 functions as the transparent electrode. More specifically, the content of the above-described material is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less, or 95% by mass or more and 100% by mass or less with respect to the total mass of the second electrode layer 106.

A thickness of the second electrode layer 106 is not particularly limited, and is, for example, 100 nm or more and 1,500 nm or less, or 200 nm or more and 1,000 nm or less. When the thickness of the second electrode layer 106 is within the above-described range, the solar cell tends to be lightened or flexible while the current can be sufficiently extracted without loss.

1.8. Grid electrode

The grid electrode 107 is provided, for example, to extract electricity from the second electrode layer 106. A material for the grid electrode 107 is not particularly limited as long as it has conductivity, and for example, a metal such as Mo, Cr, Ag, Cu, Ni, Al, and Ti; a conductive inorganic compound other than the metal; or a conductive organic compound can be used.

A content of the above-described material in the grid electrode 107 is not particularly limited as long as the grid electrode 107 functions as an electrode. More specifically, the content of the above-described material is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less with respect to the total mass of the grid electrode 107.

A thickness of the grid electrode 107 is not particularly limited, and is, for example, 5 $\mu$m or more and 50 $\mu$m or less. When the thickness of the grid electrode 107 is within the above-described range, the solar cell tends to be lightened or flexible while the current can be sufficiently extracted without loss.

2. Manufacturing method for solar cell

In the manufacturing method for the solar cell 100 according to the present embodiment, the solar cell 100 includes at least, in the following order, the first electrode layer 101, the light absorption layer 103, the first electron transport layer 104 that is the n-type semiconductor containing indium sulfide or indium sulfide to which another element is added, the second electron transport layer 105 that is the n-type oxide semiconductor to which a hydrogen element is added, and the second electrode layer 106, and the manufacturing method includes a first electron transport layer-forming step of forming the first electron transport layer 104 on a substrate including the light absorption layer 103 by sputtering, and a second electron transport layer-forming step of forming the second electron transport layer 105 on the first electron transport layer 104 by sputtering while supplying a gas including an oxygen source and a hydrogen source.

In the solar cell 100 manufactured by the manufacturing method according to the present embodiment, the first electron transport layer 104 that is the n-type semiconductor containing indium sulfide or indium sulfide to which another element is added is provided between the light absorption layer 103 and the second electron transport layer 105, so that even when the solar cell 100 is exposed to a high temperature environment, alkali metal elements contained in the light absorption layer 103 can be prevented from being diffused to the second electrode layer 106; and as a result, the solar cell 100 tends to have excellent heat resistance. It is considered that this is because the first electron transport layer 104 that is the n-type semiconductor containing indium sulfide or indium sulfide to which another element is added functions as a diffusion prevention layer for preventing the alkali metal element of the light absorption layer 103 from diffusing, but the cause thereof is not limited thereto.

In the manufacturing method for a solar cell in the related art, when the electron transport layer in the solar cell is formed in a two-layer structure and the electron transport layer on the light absorption layer side contains indium sulfide in order to improve the heat resistance of the solar cell, if the other electron transport layer is formed on the electron transport layer containing indium sulfide by sputtering, the electron transport layer containing indium sulfide is easily damaged, so that the other electron transport layer cannot be formed by sputtering. Therefore, in the solar cell in the related art, it is necessary to form the other electron transport layer while suppressing the damage to the electron transport layer containing indium sulfide by a high-cost film forming method such as an atomic layer deposition method and a chemical solution deposition method. In addition, since most of steps in the manufacturing method for the solar cell are dry processes while the film forming method such as the chemical solution deposition method is a wet process, when the wet process is used only for forming the other electron transport layer, there is a disadvantage that the manufacturing costs are high and the manufacturing takes time.

On the other hand, in the manufacturing method for the solar cell 100 according to the present embodiment, by performing sputtering while supplying the gas including the oxygen source and the hydrogen source, the second electron transport layer 105 that is the n-type oxide semiconductor can be formed, by sputtering, on the first electron transport layer 104 that is the n-type semiconductor containing indium sulfide or indium sulfide to which another element is added, while suppressing the damage to the first electron transport layer 104, so that it is not necessary to use the high-cost film forming method such as the atomic layer deposition method and the chemical solution deposition method. It is considered that, when the sputtering is performed in an environment including the oxygen source, active species generated from the oxygen source, such as oxygen plasma, are generated; and when the active species such as the oxygen plasma are excessively generated, the first electron transport layer 104 that is the n-type semiconductor containing indium sulfide or indium sulfide to which another element is added is damaged. On the other hand, in the manufacturing method according to the present embodiment, since the gas supplied during the sputtering includes the hydrogen source, an oxygen source concentration in the supply gas is within an appropriate range, and the hydrogen interacts with the oxygen, so that the generation of the active species such as the oxygen plasma is appropriately suppressed. Accordingly, it is considered that the damage to the first electron transport layer 104 that is the n-type semiconductor containing indium sulfide or indium sulfide to which another element is added by the active species such as the oxygen plasma is reduced, so that the second electron transport layer 105 that is the n-type oxide semiconductor can be formed on the first electron transport layer 104 by sputtering while suppressing the damage to the first electron transport layer 104. However, the cause thereof is not limited to the above.

In addition, since the sputtering is a dry process as in the steps other than the film formation of the electron transport layer in the manufacturing method for the solar cell, the solar cell 100 can be manufactured by preparing only the environment for the dry process without preparing both of the environments for the wet process and for the dry process when manufacturing the solar cell 100, so that the manufacturing costs tend to be reduced and the time required for the manufacturing tends to be reduced.

Therefore, it is considered that the solar cell 100 manufactured by the manufacturing method according to the present embodiment has high heat resistance and low manufacturing costs. However, the cause thereof is not limited to the above.

Hereinafter, each step that can be included in the manufacturing method for the solar cell 100 according to the present embodiment will be described in detail. In the present embodiment, the wet process means a step using a solution. In addition, the dry process means a step using no solution.

2.1. First electrode layer-forming step

In a first electrode layer-forming step, for example, the first electrode layer 101 may be formed on the substrate 108. Examples of a method of forming the first electrode layer 101 include the dry process and the wet process, and the dry process is preferable. The dry process is not particularly limited, and examples thereof include a method of forming the first electrode layer 101 that is the metal conductive layer by sputtering. Film formation conditions of the sputtering are not particularly limited, and may be, for example, applied power: 1.0 to 3.0 W/cm$^2$, film formation atmosphere: argon atmosphere, and film formation pressure: 0.5 to 3.0 Pa. In addition, a temperature of the atmosphere and a temperature of a substrate to be sputtered during the sputtering may not be controlled. The substrate to be sputtered is a substrate on a stage when performing the sputtering, and is a substrate on which a compound derived from a sputtering target is laminated. In the first electrode layer-forming step, for example, the substrate 108 may be used as the substrate to be sputtered.

2.2. Hole transport layer-forming step

In a hole transport layer-forming step, for example, the hole transport layer 102 may be formed on the first electrode layer 101. Examples of a method of forming the hole transport layer 102 include the dry process and the wet process, and the dry process is preferable. The dry process is not particularly limited, and examples thereof include a method of forming the hole transport layer 102 that is a p-type semiconductor containing an inorganic compound by sputtering. Film formation conditions of the sputtering are not particularly limited, and may be, for example, applied power: 0.5 to 3.0 W/cm$^2$, film formation atmosphere: argon atmosphere, and film formation pressure: 0.5 to 3.0 Pa. In addition, a temperature of the atmosphere and a temperature of the substrate to be sputtered during the sputtering may not be controlled. In addition, when forming the light absorption layer 103, a method of forming a compound of the element of the first electrode layer 101 and the element included in the light absorption layer 103 and forming the hole transport layer 102 between the first electrode layer 101 and the light absorption layer 103 may be used.

2.3. Light absorption layer-forming step

In a light absorption layer-forming step, for example, the light absorption layer 103 may be formed on the hole transport layer 102. When the hole transport layer 102 is not provided, the light absorption layer 103 may be formed on the first electrode layer 101. Examples of a method of forming the light absorption layer 103 include the dry process and the wet process, and the dry process is preferable. The dry process is not particularly limited, and examples thereof include a method of forming the light absorption layer 103 containing a chalcopyrite compound or a kesterite compound by sputtering. Film formation conditions of the sputtering are not particularly limited, and may be, for example, applied power: 0.5 to 3.0 W/cm$^2$, film formation atmosphere: argon atmosphere, and film formation pressure: 0.5 to 3.0 Pa. In addition, a temperature of the atmosphere and a temperature of the substrate to be sputtered during the sputtering may not be controlled. In addition, the laminate after the sputtering may be annealed at 350°C or higher and 650°C or lower in a nitrogen, selenium, or sulfur atmosphere.

When the light absorption layer 103 includes the alkali metal element, it is preferable that, in the light absorption layer-forming step, the light absorption layer 103 containing a chalcopyrite compound or a kesterite compound is formed by the sputtering using a sputtering target to which the alkali metal element is added. In addition, a method of adding the alkali metal element to the substrate 108 or the first electrode layer 101 and thermally diffusing the alkali metal element to the light absorption layer 103 when forming the light absorption layer 103 may be used.

2.4. First electron transport layer-forming step

In the first electron transport layer-forming step, the first electron transport layer 104 is formed on the substrate including the light absorption layer 103 by the sputtering. In the first electron transport layer-forming step, for example, the above-described substrate may have the light absorption layer 103 on the outermost layer, and the light absorption layer 103 may contain the chalcopyrite compound or the kesterite compound.

Film formation conditions of the sputtering are not particularly limited, and may be, for example, applied power: 0.5 to 3.0 W/cm$^2$, film formation atmosphere: argon atmosphere, and film formation pressure: 0.5 to 3.0 Pa when the first electron transport layer 104 is the n-type semiconductor containing indium sulfide. In addition, a temperature of the atmosphere may not be controlled during the sputtering. On the other hand, during the sputtering, it is preferable that the substrate including the light absorption layer 103 is heated at 150°C or higher and 250°C or lower; it is preferable that the substrate is heated at 160°C or higher and 250°C or lower; it is preferable that the substrate is heated at 170°C or higher and 250°C or lower; it is preferable that the substrate is heated at 180°C or higher and 250°C or lower; it is preferable that the substrate is heated at 190°C or higher and 250°C or lower; and it is preferable that the substrate is heated at 200°C or higher and 250°C or lower. When a metal substrate is used as the substrate 108, the temperature of the substrate and the temperature of the heating are substantially the same.

When the first electron transport layer 104 is the n-type semiconductor containing indium sulfide to which an oxygen element is added, the film formation conditions are not particularly limited, and for example, the first electron transport layer 104 that is the n-type semiconductor containing indium sulfide to which an oxygen element is added can be formed by performing the sputtering with the film forming atmosphere set to an argon-oxygen mixed gas atmosphere and the other film formation conditions set to the same conditions as in the n-type semiconductor containing indium sulfide.

When the first electron transport layer 104 is the n-type semiconductor containing indium sulfide to which an alkali metal element is added, the film formation conditions are not particularly limited, and for example, the first electron transport layer 104 that is the n-type semiconductor containing indium sulfide to which an alkali metal element is added can be formed by performing the sputtering with the sputtering target to which the alkali metal element is added and the other film formation conditions set to the same conditions as in the n-type semiconductor containing indium sulfide.

When the first electron transport layer 104 is the n-type semiconductor containing indium sulfide to which an oxygen element and an alkali metal element are added, the film formation conditions are not particularly limited, and for example, the first electron transport layer 104 that is the n-type semiconductor containing indium sulfide to which an oxygen element and an alkali metal element are added can be formed by performing the sputtering with the film forming atmosphere set to an argon-oxygen mixed gas atmosphere and the sputtering target to which the alkali metal element is added, and the other film formation conditions set to the same conditions as in the n-type semiconductor containing indium sulfide.

2.5. Second electron transport layer-forming step

In the second electron transport layer-forming step, the second electron transport layer 105 is formed on the first electron transport layer 104 by the sputtering while supplying the gas including the oxygen source and the hydrogen source.

The sputtering target need only contain an element contained in the n-type oxide semiconductor to be formed, and preferably contains a metal element contained in the n-type oxide semiconductor to be formed, and preferably contains an oxide of a metal contained in the n-type oxide semiconductor to be formed. A content of the metal element and a content of the other elements including the oxygen element and the sulfur element in the n-type oxide semiconductor to be formed are not particularly limited, but can be controlled, for example, by adjusting the element to be added to the sputtering target.

As the sputtering target, titanium oxide, a mixture of zinc oxide and zinc sulfide, or a mixture of zinc oxide and titanium oxide is preferable, and a mixture of zinc oxide and titanium oxide is more preferable. When the n-type oxide semiconductor contains titanium oxide, it is preferable to use titanium oxide as the sputtering target; when the n-type oxide semiconductor contains zinc oxide to which a sulfur element is added, it is preferable to use a mixture of zinc oxide and zinc sulfide as the sputtering target; and when the n-type oxide semiconductor contains zinc oxide to which a titanium element is added, it is preferable to use a mixture of zinc oxide and titanium oxide as the sputtering target. A content of the titanium oxide in the mixture of zinc oxide and titanium oxide as the sputtering target is preferably 4.0% by mass or more and 20% by mass or less, 5.0% by mass or more and 19% by mass or less, or 6.0% by mass or more and 18% by mass or less with respect to the total mass of the mixture.

The gas supplied during the sputtering includes an oxygen source and a hydrogen source. The gas preferably includes argon gas as a main component. The oxygen source is not particularly limited as long as it is a gas including an oxygen element, and examples thereof include $H_2O$ vapor, $O_2$ gas, and $O_3$ gas; and $O_2$ gas is preferable. The hydrogen source is not particularly limited as long as it is a gas including a hydrogen element, and examples thereof include $H_2O$ vapor and $H_2$ gas; and $H_2$ gas is preferable.

A concentration of the oxygen source in the gas supplied during the sputtering is preferably 0.8% by volume or more and 1.6% by volume or less, 0.9% by volume or more and 1.5% by volume or less, or 1.0% by volume or more and 1.5% by volume or less in terms of oxygen molecules. The concentration of the oxygen source in terms of oxygen molecules is specifically calculated as follows. When the oxygen source is $H_2O$ vapor, since the $H_2O$ vapor includes one oxygen element, if a concentration of the $H_2O$ vapor in the above-described gas is 1.0% by volume, the concentration of the oxygen source in terms of oxygen molecules is 0.5% by volume, which is half of 1.0% by volume. When the oxygen source is $O_2$ gas, since the $O_2$ gas includes two oxygen elements, if a concentration of the $O_2$ gas in the above-described gas is 1.0% by volume, the concentration of the oxygen source in terms of oxygen molecules is 1.0% by volume.

A molar ratio of the hydrogen element to the oxygen element in the gas supplied during the sputtering is preferably 1.0 times or more and 2.0 times or less, 1.2 times or more and 2.0 times or less, or 1.4 times or more and 2.0 times or less. The molar ratio of the hydrogen element to the oxygen element is specifically calculated as follows. Regarding the gas in which $O_2$ gas is used as the oxygen source and $H_2O$ vapor is used as the hydrogen source, when the concentration of the oxygen source in the gas is 0.8% by volume and the concentration of the hydrogen source in the gas is 1.6% by volume, $H_2O$ vapor as the hydrogen source has two hydrogen elements and one oxygen element per molecule, and $O_2$ gas as the oxygen source has two oxygen elements per molecule. Therefore, the molar ratio of the hydrogen element to the oxygen element is calculated as (1.6 x 2) ÷ (1.6 + 0.8 x 2) = 1.0 times.

A concentration of the argon gas in the gas supplied during the sputtering is not particularly limited, and is, for example, 90.0% by volume or more and 99.0% by volume or less, 91.0% by volume or more and 98.5% by volume or less, 92.0% by volume or more and 98.0% by volume or less, 93.0% by volume or more and 97.5% by volume or less, or 94.0% by volume or more and 97.0% by volume or less.

During performing the sputtering, it is preferable that a laminate, which includes the substrate including the light absorption layer 103 and the first electron transport layer 104 formed on the substrate, is heated at 100°C or higher and 200°C or lower, and it is preferable that the laminate is heated at 125°C or higher and 175°C or lower. When a metal substrate is used as the substrate 108, the temperature of the above-described laminate and the temperature of the heating are substantially the same.

Other film formation conditions of the sputtering are not particularly limited, and may be, for example, applied power: 0.5 to 3.0 W/cm$^2$ and film formation pressure: 0.5 to 3.0 Pa. In addition, a temperature of the atmosphere may not be controlled during the sputtering.

2.6. Second electrode layer-forming step

In a second electrode layer-forming step, for example, the second electrode layer 106 may be formed on the second electron transport layer 105. Examples of a method of forming the second electrode layer 106 include the dry process and the wet process, and the dry process is preferable. The dry process is not particularly limited, and examples thereof include a method of forming the second electrode layer 106 that is the transparent electrode layer by a sputtering. Film formation conditions of the sputtering are not particularly limited, and may be, for example, applied power: 0.5 to 3.0 W/cm$^2$, film formation atmosphere: argon atmosphere, and film formation pressure: 0.5 to 3.0 Pa. In addition, a temperature of the atmosphere and a temperature of the substrate to be sputtered during the sputtering may not be controlled.

2.7. Grid electrode-forming step

In a grid electrode-forming step, for example, the grid electrode 107 may be formed on the second electrode layer 106. Examples of a method of forming the grid electrode 107 include the dry process and the wet process. Specific examples thereof include a sputtering, a vapor deposition, a method of printing a paste-like conductive material on the second electrode layer 106, and a method of crimping a conductive wire.

3. Method of using solar cell

The solar cell 100 according to the present embodiment can be used in a normal temperature environment in which the temperature of the solar cell is approximately 45°C to 85°C, as in the solar cell in the related art. In addition, the solar cell 100 according to the present embodiment can be suitably used in a high-temperature environment in which the temperature of the solar cell exceeds 85°C (for example, in space, in the stratosphere, in deserts, in tropical regions, on rooftops of buildings, on roofs of automobiles, or on outer walls of airplanes), unlike the solar cell in the related art.
In addition, the solar cell 100 according to the present embodiment can be used as an independent power supply device for streetlights, sensors, digital signage, and the like. In addition, the solar cell 100 according to the present embodiment can be used as a mobile energy device.

<Addenda>

The embodiment according to the present disclosure includes the following aspects.

[1] A solar cell including at least, in the following order:

a first electrode layer;
a light absorption layer;
a first electron transport layer that is an n-type semiconductor containing indium sulfide or indium sulfide to which another element is added;
a second electron transport layer that is an n-type oxide semiconductor to which a hydrogen element is added; and
a second electrode layer.

[2] The solar cell according to [1],

in which the first electron transport layer is provided on the light absorption layer, and
the second electron transport layer is provided on the first electron transport layer.

[3] The solar cell according to [1] or [2],

in which a thickness of the first electron transport layer is 10 nm or more and 40 nm or less, and
a thickness of the second electron transport layer is 50 nm or more and 120 nm or less.

[4] The solar cell according to any one of [1] to [3],
in which the light absorption layer contains a chalcopyrite compound or a kesterite compound.
[5] The solar cell according to any one of [1] to [4],
in which the n-type oxide semiconductor is an oxide semiconductor having a band gap of 3.3 eV or more, a carrier concentration of $1.0 \times 10^{20}$ cm$^{-3}$ or less, and a refractive index of 2.1 or more.

13

[6] The solar cell according to [5],
in which the n-type oxide semiconductor contains titanium oxide, zinc oxide to which a sulfur element is added, or zinc oxide to which a titanium element is added.

[7] A manufacturing method for a solar cell including at least, in the following order, a first electrode layer, a light absorption layer, a first electron transport layer that is an n-type semiconductor containing indium sulfide or indium sulfide to which another element is added, a second electron transport layer that is an n-type oxide semiconductor to which a hydrogen element is added, and a second electrode layer, the manufacturing method including:

> a first electron transport layer-forming step of forming the first electron transport layer on a substrate including the light absorption layer by sputtering; and
> a second electron transport layer-forming step of forming the second electron transport layer on the first electron transport layer by sputtering while supplying a gas including an oxygen source and a hydrogen source.

[8] The manufacturing method according to [7],

> in which the substrate has the light absorption layer on an outermost layer, and
> the light absorption layer contains a chalcopyrite compound or a kesterite compound.

[9] The manufacturing method according to [7] or [8],
in which a concentration of the oxygen source in the gas supplied in the second electron transport layer-forming step is 0.8% by volume or more and 1.6% by volume or less in terms of oxygen molecules.

[10] The manufacturing method according to any one of [7] to [9],
in which a molar ratio of the hydrogen element to an oxygen element in the gas supplied in the second electron transport layer-forming step is 1.0 times or more and 2.0 times or less.

[11] The manufacturing method according to any one of [7] to [10],
in which the n-type oxide semiconductor is an oxide semiconductor having a band gap of 3.3 eV or more, a carrier concentration of $1.0 \times 10^{20}$ cm$^{-3}$ or less, and a refractive index of 2.1 or more.

[12] The manufacturing method according to [11],
in which the n-type oxide semiconductor contains titanium oxide, zinc oxide to which a sulfur element is added, or zinc oxide to which a titanium element is added.

[13] The manufacturing method according to any one of [7] to [12],

> in which the n-type oxide semiconductor is zinc oxide to which a titanium element is added, and
> the second electron transport layer-forming step is performed using a mixture of zinc oxide and titanium oxide, which contains 4.0% by mass or more and 20% by mass or less of the titanium oxide, as a sputtering target.

[14] The manufacturing method according to [13],

> in which the first electron transport layer-forming step is performed while heating the substrate at 150°C or higher and 250°C or lower, and
> the second electron transport layer-forming step is performed while heating a laminate including the substrate and the first electron transport layer formed on the substrate at 100°C or higher and 200°C or lower.

Examples

The present invention will be described in detail by Examples and Comparative Examples. The present invention is not limited by Examples. In addition, unless otherwise specified, the operation was carried out at room temperature (25°C) and 1 atm.

1. Production of solar cell

In Example 1, a titanium foil having a thickness of 50 μm was used as the substrate 108. On the substrate 108, the first electrode layer 101 containing metal molybdenum was formed by sputtering at a thickness of 600 nm.

Next, the light absorption layer 103 including a sodium element and a potassium element that are alkali metal elements and containing the CIGSS compound was formed on the first electrode layer 101 by sputtering at a thickness of 2 μm. In addition, when forming the light absorption layer 103, the hole transport layer 102 containing molybdenum selenide was formed between the first electrode layer 101 and the light absorption layer 103 at a thickness of 50 nm.

Next, the first electron transport layer 104 that is an n-type semiconductor containing indium sulfide was formed on the light absorption layer 103 by sputtering at a thickness of 30 nm.

Conditions of the sputtering were as follows.

Sputtering target: indium sulfide
Film formation atmosphere: argon atmosphere
Heating temperature of substrate to be sputtered during film formation: 200°C

Next, the second electron transport layer 105 that is an n-type oxide semiconductor containing zinc oxide to which a hydrogen element and a titanium element were added was formed on the first electron transport layer 104 by sputtering at a thickness of 70 nm. When the amount of the hydrogen element in the second electron transport layer 105 was measured by an RBS/HFS method, the molar ratio of the hydrogen element to all metal elements was 0.011. In addition, conditions of the sputtering were as follows.

Sputtering target: mixture of zinc oxide and titanium oxide (mixing ratio is shown in Tables 1 to 3)
Film formation atmosphere: argon/hydrogen gas/oxygen gas atmosphere (proportion of hydrogen gas in mixed gas supplied: 1.6% by volume, proportion of oxygen gas in mixed gas: 1.2% by volume)
Heating temperature of substrate to be sputtered during film formation: 160°C

Next, the second electrode layer 106 that is a transparent electrode layer containing hydrogen-containing indium oxide (IOH) was formed on the second electron transport layer 105 by sputtering at a thickness of 300 nm.

In this manner, a solar cell of Example 1 was produced. Solar cells of Examples 2 to 11 were produced in the same manner as in Example 1, except that parameters shown in Tables 1 to 3 were used. In Tables 1 to 3, "Film formation temperature of first electron transport layer (°C)" and "Film formation temperature of second electron transport layer (°C)" indicate the heating temperature of the substrate to be sputtered during the film formation. In addition, "TiO$_2$ ratio (%)" indicates a proportion of TiO$_2$ in the sputtering target used when forming the second electron transport layer 105.

A solar cell of Comparative Example 1 was produced in the same manner as in Example 1, except the first electron transport layer. In the solar cell of Comparative Example 1, the first electron transport layer that is an n-type semiconductor containing cadmium sulfide was formed on the light absorption layer by a chemical solution deposition method at a thickness of 30 nm.

A solar cell of Comparative Example 2 was produced in the same manner as in Example 1, except that the step of forming the first electron transport layer was not carried out and the conditions of the step of forming the second electron transport layer were changed. In the solar cell of Comparative Example 2, the second electron transport layer that is an n-type oxide semiconductor containing zinc oxide to which a hydrogen element and a titanium element were added was formed on the light absorption layer by sputtering at a thickness of 100 nm. Conditions of the sputtering were as follows.

Sputtering target: mixture of zinc oxide and titanium oxide (mixing ratio is shown in Tables 1 to 3)
Film formation atmosphere: argon/hydrogen gas/oxygen gas atmosphere (proportion of hydrogen gas in mixed gas supplied: 1.6% by volume, proportion of oxygen gas in the mixed gas: 1.2% by volume)
Heating temperature of substrate to be sputtered during film formation: 160°C

A solar cell of Comparative Example 3 was produced in the same manner as in Example 1, except that the step of forming the second electron transport layer was not carried out and the second electrode layer was formed on the first electron transport layer.

2. Evaluation method

2.1. Heat resistance (FF value)

Each of the solar cells obtained in Example 1, Comparative Example 1, and Comparative Example 2 was heated at 200°C for 30 minutes while being irradiated with light having an AM 1.5 solar spectrum at an irradiance of 1 kW/m$^2$ for initial stabilization. Thereafter, an FF value was measured. Furthermore, after the measurement of the FF value, each of the solar cells was heated at 150°C for 208 hours while being irradiated with light having an AM 1.5 solar spectrum at an irradiance of 1 kW/m$^2$. Thereafter, an FF value was measured. The FF value is a value obtained by dividing an output (maximum output: P$_{max}$) at an optimal operation point in an I-V curve, which is an output characteristic of the solar cell, by a product of an open-circuit voltage (V$_{oc}$) and a short-circuit current (I$_{sc}$), and is an indicator representing quality of current-voltage characteristics of the solar cell.

$$\text{FF value (\%)} = P_{max} \div (V_{oc} \times I_{sc}) \times 100$$

An I-V curve was measured under standard test conditions of the solar cell (test conditions in which light having an AM 1.5 solar spectrum was incident at an irradiance of 1 kW/m$^2$ and the solar cell temperature was 25°C).

2.2. Conversion efficiency

A conversion efficiency was measured for the solar cells obtained in Examples 2 to 11 and Comparative Example 3. The conversion efficiency is a value obtained by dividing the output (maximum output: $P_{max}$) at the optimal operation point in the I-V curve by light energy E received by the solar cell.

$$\text{Conversion efficiency (\%)} = P_{max} \div E \times 100$$

The I-V curve was measured under the same conditions as in the measurement of the FF value.

[Table 1]

| | | Comparative Example 1 | Comparative Example 2 | Example 1 |
|---|---|---|---|---|
| Type of first electron transport layer | | Cadmium sulfide | None | Indium sulfide |
| Thickness of first electron transport layer (nm) | | 30 | × | 30 |
| Film formation temperature of first electron transport layer (°C) | | 65 | × | 200 |
| Type of second electron transport layer | | Titanium-doped zinc oxide | Titanium-doped zinc oxide | Titanium-doped zinc oxide |
| Thickness of second electron transport layer (nm) | | 70 | 100 | 70 |
| Film formation temperature of second electron transport layer (°C) | | 160°C | 160°C | 160°C |
| Film formation atmosphere of second electron transport layer | | Argon-oxygen-hydrogen | Argon-oxygen-hydrogen | Argon-oxygen-hydrogen |
| TiO$_2$ ratio (%) | | 10 | 10 | 10 |
| Heat resistance | FF value before heating (%) | 67.5 | 66.1 | 70.1 |
| | FF value after heating (%) | 49.1 | 50.2 | 69.5 |
| Conversion efficiency (%) | Before heating | 13.9 | 13.8 | 15.5 |
| | After heating | 10.1 | 10.7 | 15.5 |
| Open-circuit voltage (mV) | Before heating | 576 | 589 | 599 |
| | After heating | 574 | 598 | 603 |
| Short-circuit current (mA/cm$^2$) | Before heating | 35.7 | 35.5 | 37.0 |
| | After heating | 35.7 | 35.7 | 37.0 |

[Table 2]

| | Example 2 | Example 3 | Example 4 | Example 5 | Example 6 | Example 7 | Comparative Example 3 |
|---|---|---|---|---|---|---|---|
| Type of first electron transport layer | Indium sulfide | Indium sulfide | Indium sulfide | Indium sulfide | Indium sulfide | Indium sulfide | Indium sulfide |

(continued)

|  | Example 2 | Example 3 | Example 4 | Example 5 | Example 6 | Example 7 | Comparative Example 3 |
|---|---|---|---|---|---|---|---|
| Thickness of first electron transport layer (nm) | 20 | 20 | 30 | 30 | 40 | 40 | 40 |
| Film formation temperature of first electron transport layer (°C) | 200 | 250 | 200 | 225 | 25 | 200 | 25 |
| Type of second electron transport layer | Titanium-doped zinc oxide | Titanium-doped zinc oxide | Titanium-doped zinc oxide | Titanium-doped zinc oxide | Titanium-doped zinc oxide | Titanium-doped zinc oxide | × |
| Thickness of second electron transport layer (nm) | 70 | 70 | 70 | 70 | 70 | 70 | × |
| Film formation temperature of second electron transport layer (°C) | 160°C | 160°C | 160°C | 160°C | 160°C | 160°C | × |
| Film formation atmosphere of second electron transport layer | Argon-oxygen-hydrogen | Argon-oxygen-hydrogen | Argon-oxygen-hydrogen | Argon-oxygen-hydrogen | Argon-oxygen-hydrogen | Argon-oxygen-hydrogen | × |
| $TiO_2$ ratio (%) | 10 | 10 | 10 | 10 | 10 | 10 | × |
| Conversion efficiency (%) | 14.7 | 15.6 | 15.5 | 14.7 | 13.3 | 15.7 | 0.0 |

[Table 3]

|  | Example 8 | Example 9 | Example 10 | Example 11 |
|---|---|---|---|---|
| Type of first electron transport layer | Indium sulfide | Indium sulfide | Indium sulfide | Indium sulfide |
| Thickness of first electron transport layer (nm) | 30 | 30 | 30 | 30 |
| Film formation temperature of first electron transport layer (°C) | 200 | 200 | 200 | 200 |
| Type of second electron transport layer | Titanium-doped zinc oxide | Titanium-doped zinc oxide | Titanium-doped zinc oxide | Titanium-doped zinc oxide |
| Thickness of second electron transport layer (nm) | 70 | 90 | 90 | 120 |
| Film formation temperature of second electron transport layer (°C) | 160°C | 160°C | 160°C | 160°C |
| Film formation atmosphere of second electron transport layer | Argon-oxygen-hydrogen | Argon-oxygen-hydrogen | Argon-oxygen-hydrogen | Argon-oxygen-hydrogen |
| $TiO_2$ ratio (%) | 10 | 6 | 10 | 6 |
| Conversion efficiency (%) | 15.5 | 16.2 | 15.5 | 16.9 |

3. Evaluation result

Figure 2 shows I-V curves of the solar cells obtained in Example 1, Comparative Example 1, and Comparative Example 2. In Figure 2, A corresponds to Comparative Example 1, B corresponds to Comparative Example 2, and C corresponds to Example 1. In addition, Table 1 shows the FF values of the solar cells obtained in Example 1, Comparative Example 1, and Comparative Example 2. From the above, it was found that the solar cell of Example 1 had suppressed deterioration of the current-voltage characteristics due to heating, as compared with the solar cells of Comparative Examples 1 and 2, and thus had excellent current-voltage characteristics both before and after the heating. In C of Figure 2, the I-V curve after the heating overlaps the I-V curve before the heating.

Tables 2 and 3 show the conversion efficiencies of the solar cells obtained in Examples 2 to 11 and Comparative Example 3. From the above, it was found that the solar cells of Examples 2 to 11 had an excellent conversion efficiency as compared with the solar cell of Comparative Example 3.

**Industrial Applicability**

Since the solar cell according to the present invention has excellent heat resistance, it has industrial applicability as a solar cell used in various environments such as a high temperature environment.

**Reference Signs List**

100:    solar cell
101:    first electrode layer
102:    hole transport layer
103:    light absorption layer
104:    first electron transport layer
105:    second electron transport layer
106:    second electrode layer
107:    grid electrode
108:    substrate

**Claims**

1.  A solar cell comprising at least, in the following order:

    a first electrode layer;
    a light absorption layer;
    a first electron transport layer that is an n-type semiconductor containing indium sulfide or indium sulfide to which another element is added;
    a second electron transport layer that is an n-type oxide semiconductor to which a hydrogen element is added; and
    a second electrode layer.

2.  The solar cell according to Claim 1,

    wherein the first electron transport layer is provided on the light absorption layer, and
    the second electron transport layer is provided on the first electron transport layer.

3.  The solar cell according to Claim 1,

    wherein a thickness of the first electron transport layer is 10 nm or more and 40 nm or less, and
    a thickness of the second electron transport layer is 50 nm or more and 120 nm or less.

4.  The solar cell according to any one of Claims 1 to 3,
    wherein the light absorption layer contains a chalcopyrite compound or a kesterite compound.

5.  The solar cell according to any one of Claims 1 to 3,

wherein the n-type oxide semiconductor is an oxide semiconductor having a band gap of 3.3 eV or more, a carrier concentration of $1.0 \times 10^{20}$ cm$^{-3}$ or less, and a refractive index of 2.1 or more.

6. The solar cell according to Claim 5, wherein the n-type oxide semiconductor contains titanium oxide, zinc oxide to which a sulfur element is added, or zinc oxide to which a titanium element is added.

7. A manufacturing method for a solar cell including at least, in the following order, a first electrode layer, a light absorption layer, a first electron transport layer that is an n-type semiconductor containing indium sulfide or indium sulfide to which another element is added, a second electron transport layer that is an n-type oxide semiconductor to which a hydrogen element is added, and a second electrode layer, the manufacturing method comprising:

   a first electron transport layer-forming step of forming the first electron transport layer on a substrate including the light absorption layer by sputtering; and
   a second electron transport layer-forming step of forming the second electron transport layer on the first electron transport layer by sputtering while supplying a gas including an oxygen source and a hydrogen source.

8. The manufacturing method according to Claim 7,

   wherein the substrate has the light absorption layer on an outermost layer, and
   the light absorption layer contains a chalcopyrite compound or a kesterite compound.

9. The manufacturing method according to Claim 7 or 8, wherein a concentration of the oxygen source in the gas supplied in the second electron transport layer-forming step is 0.8% by volume or more and 1.6% by volume or less in terms of oxygen molecules.

10. The manufacturing method according to Claim 7 or 8, wherein a molar ratio of the hydrogen element to an oxygen element in the gas supplied in the second electron transport layer-forming step is 1.0 times or more and 2.0 times or less.

11. The manufacturing method according to Claim 7 or 8, wherein the n-type oxide semiconductor is an oxide semiconductor having a band gap of 3.3 eV or more, a carrier concentration of $1.0 \times 10^{20}$ cm$^{-3}$ or less, and a refractive index of 2.1 or more.

12. The manufacturing method according to Claim 11, wherein the n-type oxide semiconductor contains titanium oxide, zinc oxide to which a sulfur element is added, or zinc oxide to which a titanium element is added.

13. The manufacturing method according to Claim 7 or 8,

   wherein the n-type oxide semiconductor is zinc oxide to which a titanium element is added, and
   the second electron transport layer-forming step is performed using a mixture of zinc oxide and titanium oxide, which contains 4.0% by mass or more and 20% by mass or less of the titanium oxide, as a sputtering target.

14. The manufacturing method according to Claim 13,

   wherein the first electron transport layer-forming step is performed while heating the substrate at 150°C or higher and 250°C or lower, and
   the second electron transport layer-forming step is performed while heating a laminate including the substrate and the first electron transport layer formed on the substrate at 100°C or higher and 200°C or lower.

[Fig. 1]

100

107
106
105
104
103
102
101
108

[Fig. 2]

A

Current density (mA/cm²)

Voltage (mV)

—— I-V Curve before heating
----- I-V Curve after heating

B

Current density (mA/cm²)

Voltage (mV)

—— I-V Curve before heating
----- I-V Curve after heating

C

Current density (mA/cm²)

Voltage (mV)

—— I-V Curve before heating
----- I-V Curve after heating

## INTERNATIONAL SEARCH REPORT

| International application No. |
| --- |
| **PCT/JP2024/029137** |

### A. CLASSIFICATION OF SUBJECT MATTER

*H01L 31/0749*(2012.01)i; *H01L 31/18*(2006.01)i
FI:  H01L31/06 460; H01L31/04 420

According to International Patent Classification (IPC) or to both national classification and IPC

### B. FIELDS SEARCHED

Minimum documentation searched (classification system followed by classification symbols)

H01L31/06-31/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2011-181695 A (DAIWASANGYO) 15 September 2011 (2011-09-15) paragraphs [0024]-[0035], fig. 1 | 1-2, 4-6 |
| A | | 3, 7-14 |
| Y | JP 2011-023520 A (PANASONIC ELECTRIC WORKS CO., LTD.) 03 February 2011 (2011-02-03) paragraphs [0102]-[0108] | 1-6 |
| A | | 7-14 |
| Y | JP 2009-252903 A (FUJIFILM CORPORATION) 29 October 2009 (2009-10-29) claims 1-4, paragraphs [0008]-[0009], [0042] | 1-6 |
| Y | JP 2012-099807 A (ALTA DEVICES, INC,) 24 May 2012 (2012-05-24) paragraph [0047] | 1-6 |
| Y | JP 2012-079728 A (KYOCERA CORPORATION) 19 April 2012 (2012-04-19) paragraphs [0017]-[0019], fig. 1 | 3 |

[✓] Further documents are listed in the continuation of Box C.   [✓] See patent family annex.

|  | |  |  |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **09 September 2024** | **24 September 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT

International application No.

**PCT/JP2024/029137**

C. DOCUMENTS CONSIDERED TO BE RELEVANT

| Category* | Citation of document, with indication, where appropriate, of the relevant passages | Relevant to claim No. |
|---|---|---|
| A | JP 2013-118265 A (SHOWA SHELL SEKIYU K.K.) 13 June 2013 (2013-06-13) <br> entire text, all drawings | 1-14 |
| A | JP 10-226598 A (SANYO ELECTRIC CO., LTD.) 25 August 1998 (1998-08-25) <br> entire text, all drawings | 1-14 |

Form PCT/ISA/210 (second sheet) (July 2022)

**INTERNATIONAL SEARCH REPORT**
Information on patent family members

International application No.

**PCT/JP2024/029137**

| Patent document cited in search report | | | Publication date (day/month/year) | Patent family member(s) | Publication date (day/month/year) |
|---|---|---|---|---|---|
| JP | 2011-181695 | A | 15 September 2011 | (Family: none) | |
| JP | 2011-023520 | A | 03 February 2011 | (Family: none) | |
| JP | 2009-252903 | A | 29 October 2009 | (Family: none) | |
| JP | 2012-099807 | A | 24 May 2012 | US 2012/0104460 A1 paragraph [0053] | |
| JP | 2012-079728 | A | 19 April 2012 | (Family: none) | |
| JP | 2013-118265 | A | 13 June 2013 | US 2014/0315348 A1 | |
| JP | 10-226598 | A | 25 August 1998 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 1820358

- JP 5635497 B

**Non-patent literature cited in the description**

- *Res. Appl.*, 2015, vol. 23, 537-545

- *Appl. Sci.*, 2020, vol. 10, 1052